# EUROPEAN PATENT APPLICATION

(11) **EP 1 825 995 A1**
(43) Date of publication of application: **29.08.2007**
(21) Application number: 04792886.6
(22) Date of filing: 22.10.2004
(51) Int. Cl.: B32B 9/00, C23C 14/08, H05B 33/02, H01B 5/14

(54) **GAS BARRIER TRANSPARENT RESIN SUBSTRATE, METHOD FOR MANUFACTURE THEREOF, AND FLEXIBLE DISPLAY ELEMENT USING GAS BARRIER TRANSPARENT RESIN SUBSTRATE**

(71) Applicant: Sumitomo Metal Mining Co., Ltd., Tokyo, 105-8716 (JP)
(72) Inventor: ABE, Yoshiyuki, SUMITOMO METAL MINING CO., LTD., Ichikawa-shi, Chiba 2720835 (JP)
(74) Representative: Klingseisen, Franz
(86) International application number: PCT/JP2004/015744
(87) International publication number: WO 2006/043333

(57) **Abstract**

The object of this invention is to provide a transparent plastic substrate having better surface smoothness than prior substrates, as well as having high transparency and high gas-barrier characteristics, and to provide a flexible display element using that uses this substrate. For that purpose, a gas-barrier transparent plastic substrate is obtained such that a transparent oxide film comprising either of a tin-oxide amorphous film, or tin-oxide amorphous film containing at least one added element that is selected from among the group of silicon, germanium, aluminum, cerium and indium, at a ratio of 0.2 to 45 atomic % with respect to the total of added element and tin, is formed as gas-barrier layer on at least one surface of a plastic film base material. It is possible that the gas-barrier transparent plastic substrate be formed as bilayer where a silicon-oxide film or silicon-oxynitride film is formed on the transparent oxide film. When a transparent electrode film is further formed on it, a flexible display element can be obtained.

## Description

### BACKGROUND OF THE INVENTION

### Field of the Invention:

This invention relates to a gas-barrier type transparent plastic substrate that is used for electronic paper such as liquid-crystal display elements, electroluminescence display elements, electrophoresis type display elements and toner display elements, or film-type solar batteries. More specifically, this invention relates to a transparent plastic substrate and manufacturing method thereof that has an improved gas barrier with excellent surface smoothness characteristics and is made by forming an amorphous tin oxide type transparent oxide film.

### Description of the Related Art:

Gas-barrier type film (transparent plastic film), which is made by covering the surface of a plastic substrate or film-type substrate with a metal oxide film such as silicon oxide or aluminum oxide, has been used for packaging for the purpose of preventing decomposition of food products or drug products that require shutting out gasses such as water vapor or oxygen. In the field of electronic devices as well, it has been used in liquid-crystal display elements or solar batteries, or in flexible display elements such as electroluminescence (EL) display elements.

In recent years, as development of display elements has progressed, demands for making the gas-barrier type file used in liquid-crystal display elements and EL display elements more lightweight and larger, as well as giving the film more freedom of shape and using it in curved displays have also appeared. Therefore, use of transparent plastic or resin film base material in the place of glass substrate, which is heavy, easily breakable and difficult to use in a large surface area, is being investigated.

On the other hand, a high level of surface smoothness and gas-barrier characteristics are required in a substrate that can be used for electronic paper such as liquid-crystal display elements, and organic EL elements.

However, the gas barrier characteristics of plastic or resin film base material is inferior to a glass substrate, so there is a problem in that water vapor or oxygen can permeate through the base material and cause the liquid-crystal display elements or EL display elements to deteriorate. In order to overcome this kind of problem, development of film (transparent plastic substrate) with good gas barrier characteristics is being performed in which a metal oxide film is formed on the plastic film base material.

In Patent Document 1 (Japanese Examined Patent Application Publication No. S53-12953), a gas-barrier film is introduced in which a silicon oxide film is formed on a plastic film by vapor deposition, and in Patent Document 2 (Japanese Patent Application Publication No. S58-217344), a gas-barrier film is proposed in which an aluminum oxide film is formed. As the water-vapor transmission rate of these gas-barrier film measured by Mocon method is 1g/m²/day, which is high, it is inferior in water-vapor barrier characteristic, and there is no information about the surface smoothness of the film substrate.

Moreover, in Patent Document 3 (Japanese Patent Application Publication No. S64-59791), a moisture-proof film is proposed in which metal oxide of at least one kind of metal selected from the group In, Sn, Zn and Ti is vapor deposited on polyethylene terephthalate. However, there is no information about the surface smoothness of the moisture-proof film or water vapor transmission rate.

In order to achieve a film (transparent plastic substrate) having an even higher level of gas barrier characteristics is essential for minute manufacturing of a metal-oxide gas barrier film. Normally, a minute metal-oxide film can be easily manufactured using a sputtering method.

The sputtering method is normally a method performed under an argon gas pressure of about 10 Pa or less, where the plastic film substrate is taken to be the anode and the target is taken to be the cathode, and in which argon plasma is generated by causing a glow discharge to occur between the anode and cathode, and the positive argon ions in the plasma are caused to collide with the cathode target, causing the particles of the target component to be flicked out, and film is formed by depositing those particles on the plastic film substrate. The sputter particles that are deposited on the plastic film substrate have kinetic energy, so migration is performed on the plastic film substrate to form a minute film.

The sputtering method is categorized according to the method of generating argon plasma, and the method in which high-frequency plasma is used is called the 'high-frequency sputtering' method, and the method in which direct-current plasma is used is called the 'direct-current sputtering' method. Also, a method in which a magnet is located behind the target to concentrate the argon plasma directly on the target in order to improve the collision efficiency of argon ions even under low gas pressure is called the 'magnetron sputtering' method.

The high-frequency sputtering method is not only capable of forming a conductive film material, but is also capable of stably forming an insulating or highly resistant film material from an insulating or highly resistant target. In the high-frequency sputtering method, normally, in order that the electric power can be used efficiently for the electric discharge, an impedance matching circuit, comprising a coil and capacitor, is placed between the high-frequency power source and target, so the manufacturing cost increases. Also, since it is necessary to control the impedance matching circuit according to the sputter conditions, operating the high-frequency sputtering method is difficult and it is inferior in reproducibility of the film-formation speed.

On the other hand, the direct-current sputtering method is capable of forming a conductive thin film from a conductive target, however, it is not suitable for forming an insulating or highly resistant film because arching occurs easily. Also, it is easier to operate the direct-current sputtering method when compared with the high-frequency sputtering method, and it has excellent reproducibility of the film-formation speed. Therefore, it has advantages from the aspect of cost and controllability, and is widely used industrially.

Moreover, even in the direct-current sputtering method, there is also a sputtering method (DC pulsing method) that periodically stops the negative voltage that is applied to the target and applies a low positive voltage to neutralize the positive charging with electrons. By this method, it is capable of forming an insulating film (silicon oxide, silicon oxynitride, titanium oxide, etc.) in reactive sputtering that uses an oxygen gas as reactive gas while at the same time suppressing arching, and it has advantages in that it is not necessary to control the impedance matching circuit as in the case of the high-frequency sputtering method, and the film-formation speed is faster than in the high-frequency sputtering method.

Meanwhile, there has been a rush to put organic EL displays and high-definition color liquid-crystal displays into practical use. Of these, in the case of organic EL displays, problems are known in that when water vapor penetrates into the organic EL display elements, deterioration of the display becomes extreme due to moisture at the boundary between the cathode layer and organic-function layer, and peeling occurs between the organic-function layer and cathode causing portions that do not emit light, or in other words, causing dark spots to occur. The gas-barrier characteristics required for film (transparent plastic substrate) that can be used in these kinds of displays (flexible display elements) is said to be a water-vapor transmission rate of about 0.01 g/m²/day according to the Mocon method. Of course, needless to say, transparency is also required for these films (transparent plastic substrate).

In Patent Document 4 (Japanese Patent Application Publication No. 2002-100469), forming a silicon-oxynitride film on a plastic film substrate is disclosed as a transparent plastic substrate having water-vapor barrier characteristics. A silicon-nitride film has better gas-barrier characteristics than a silicon-oxide film or aluminum-oxide film, however, since it is normally a colored or tinted film, it cannot be used as the gas-barrier film on a transparent plastic substrate for a display that requires transparency. In this document, it is disclosed that silicon oxynitride, in which part of the nitrogen in the silicon nitride is replaced with oxygen, has transparency and maintains the gas barrier characteristic at a high level, when the ratio of nitrogen/oxygen is 0.1 to 2.9.

However, there is a problem in that in the sputtering method, it is difficult to form a metal-oxide film or metal-oxynitride film, and even when forming a silicon-oxynitride film having a film thickness (for example, 200 nm) that makes it possible to realize water-vapor barrier characteristics, the surface smoothness of the film (transparent plastic substrate) is greatly lost.

As described above, the properties required for the substrate for a liquid-crystal display or organic EL display are surface smoothness and gas-barrier characteristics.

In order to fulfill the surface smoothness of the substrate, it is required to form a transparent conductive film having a smooth surface and low resistance, and particularly in the case of the electrodes for an organic EL display, a super thin (several hundred nm) multi-layered film made of an organic compound is formed on the transparent conductive films, so excellent surface smoothness is required for the transparent conductive film. In an organic EL display element, electrons and electron holes flow to the two electrodes, and combine together inside the super thin organic compound layer to emit light, however, there is a problem in that when there are minute protrusions on the surface of the transparent electrode film, the current flow becomes concentrated at the protrusions and leaks, causing light not to be emitted.

The surface smoothness of the transparent electrode film is generally greatly influenced by the crystallinity of the transparent electrode film. Even for transparent electrode films having the same composition, an amorphous film in which there are no grain boundaries has better surface smoothness. The surface smoothness of the transparent electrode film not only depends on the crystallinity of the transparent electrode film itself, but also greatly depends on the surface smoothness of the plastic film substrate beneath it, so it is necessary to form an amorphous transparent electrode film on a smooth plastic film base material or transparent plastic substrate.
[Patent Document 1]
   Japanese Examined Patent Application Publication No. S53-12953
[Patent Document 2]
   Japanese Patent Application Publication No. S58-217344
[Patent Document 3]
   Japanese Patent Application Publication No. S64-59791
[Patent Document 4]
   Japanese Patent Application Publication No. 2002-100469

### SUMMARY OF THE INVENTION

### [Problems to be Solved by the Invention]

The object of this invention is to provide a transparent plastic substrate having better surface smoothness than prior substrates, as well as having high transparency and high gas-barrier characteristics, and to provide a transparent conductive substrate (flexible display element) that uses this substrate.

### [Means for Solving the Problems]

The gas-barrier transparent plastic substrate of this invention comprises a gas-barrier layer formed on at least one surface of a plastic film base material, wherein the gas-barrier layer has a tin-oxide type amorphous transparent oxide film. Here, the term tin-oxide type film also includes the case of just tin-oxide film, as well as the case of tin-oxide film with other added elements.

The gas-barrier layer can be formed with not only a tin-oxide type amorphous transparent oxide film but also a silicon-oxide film or silicon-oxynitride film.

The tin-oxide type amorphous transparent oxide film preferably comprises either of tin oxide, or tin oxide containing at least one added element that is selected from among the group of silicon, germanium, aluminum, cerium and indium. It is preferred that the added element be included at a ratio of 0.2 to 45 atomic % with respect to the total of added element and tin. Also, it is preferred that the centerline average surface roughness Ra on the surface of the gas-barrier layer be 1.5 nm or less. Moreover, it is preferred that the water-vapor transmission rate by the Mocon method and measured according to JIS standard method K7129-1992, be less than 0.01 g/m²/day.

It is possible to form a transparent electrode film having a surface resistance of 200 ohm/square on the surface of the gas-barrier layer of the gas-barrier transparent plastic substrates. Also, it is preferred that the centerline average surface roughness Ra on the surface of the transparent electrode film be 1.8 nm or less. Moreover, it is preferred that the transparent electrode film have an amorphous structure with indium oxide as the main component and also contains at least one element selected from the group of tin, tungsten, silicon and germanium.

With the use of the gas-barrier transparent plastic substrates, flexible display elements can be obtained. The obtained flexible display elements have excellent light-emitting characteristics. These display elements include electronic paper such as liquid-crystal display elements, organic or inorganic EL display elements, electrophoresis type display elements and toner display elements.

The organic EL display elements comprises, for example, an anode, a cathode, an organic layer sandwiched between the both electrodes wherein the organic layer is constructed such that it contains an organic light-emitting layer that emits light by the reuniting of the electron holes that are supplied from the anode with the electrons that are supplied from the cathode.

In the method of manufacturing the gas-barrier transparent plastic substrate of this invention, when manufacturing the tin-oxide type amorphous film with a sputtering method, a tin-oxide type sintered body can be used as the raw material.

As the above sputtering method, a direct-current pulsing method can be used.

The tin-oxide type sintered body used for manufacturing the gas-barrier transparent plastic substrate of this invention, preferably comprises either of tin oxide, or tin oxide containing at least one added element selected from among the group of silicon, germanium, aluminum, cerium, and indium.

It is preferred that the tin-oxide type sintered body contain at least one added element at a ratio with respect to the total amount of added element and tin of 0.2 to 45 atomic %.

A sputtering target of this invention comprises either of tin-oxide type sintered body consisting of tin oxide, or tin-oxide type sintered body consisting of tin oxide containing at least one added element selected from among the group of silicon, germanium, aluminum, cerium, and indium.

### [Effect of the Invention]

With this invention it is possible to provide a transparent oxide film that has excellent moisture-proof characteristics and surface smoothness. Using the obtained transparent oxide film, it is possible to form a gas-barrier transparent plastic substrate, and using that gas-barrier transparent plastic substrate it is possible to manufacture electronic paper such as liquid-crystal display elements, organic or inorganic EL display elements, electrophoresis type display elements and toner display elements. Therefore, this invention has extremely high industrial value.

### DESCRIPTION OF THE PREFERRED EMBODIMENTS

The inventors performed tests for the purpose of overcoming the aforementioned problems, and both excellent waterproof characteristics and surface smoothness were seen for a transparent oxide film having an amorphous structure and including at least one added element selected from the group of silicon, germanium, aluminum, cerium and indium added to tin oxide; and by using this transparent oxide film, it was confirmed that it was possible to form a gas-barrier type transparent plastic substrate; and using this gas-barrier transparent plastic substrate, it was possible to manufacture electronic paper such as liquid-crystal display elements, electroluminescence (EL) display elements, electrophoretic-type display elements and toner-display elements, which led to this invention.

The tin-oxide type amorphous film of this invention has an amorphous structure including at least one added element that is selected from among the group of silicon, germanium, aluminum, cerium and indium, and added to the tin oxide at a ratio with respect to the total of added element and tin of 0 to 45 atomic %, or more preferably, 0.2 to 45 atomic %.

Also, the gas-barrier transparent plastic substrate of this invention is formed with an amorphous tin-oxide type film formed on at least one surface of a plastic film substrate. Furthermore, it is possible to assume a structure with a silicon-oxynitride film formed on top of this.

Here, it is possible to used a tin-oxide film containing no impurities as the amorphous film, however, with a tin-oxide type film containing at least one added element selected from the aforementioned group of silicon, germanium, titanium, aluminum, cerium and indium, it is easier to obtain an amorphous film structure, so it is preferred. As mentioned above, it is preferred that the ratio of the added element be 0.2 to 45 atomic % with respect to the total of added element and tin. When the ratio is less than 0.2 atomic %, as in the case of the tin-oxide film with no impurities, it becomes difficult to obtain an amorphous film, and it becomes easier for crystallization to occur, so it becomes easier for deterioration of the surface smoothness to occur.

Moreover, in the case of manufacturing a tin-oxide film containing an added element having a ratio that is greater than 45 atomic % using the sputtering method, it is necessary to use a sputtering target that is a tin-oxide sintered body containing the added element at a ratio that is greater than 45 atomic %, however, since it is difficult to form a film with direct-current discharge using a simple direct-current discharge or direct-current pulsing method, it is not preferred. This is because, when the ratio of the added element exceeds 45 atomic %, the resistance of the tin-oxide sintered body increases, and the ratio that highly resistant material exists in the oxide phase of the added element or the compound phase formed from the added element and tin increases, and thus direct-current discharge using the normal direct-current discharge or direct-current pulsing method becomes difficult. However, even when the ratio of the added element is greater than 45 atomic %, it is possible to form a film using high-frequency discharge, and the film that is obtained shows sufficient gas-barrier characteristics.

Polyethylene terephthalate, polyethylene-2, 6-naphthalate, polycarbonate, polysulfone, polyethersulfone, polyarylate, fluoro resin, polypropylene, polyimide resin and epoxy resin can be used as the plastic film base material. The thickness of the plastic film base material is not particularly limited, however, a thickness of 0.05 mm to 1 mm is preferred.

An inorganic film can be inserted inside the plastic film base material, or the surface of the plastic film base material can be coated with a different plastic such as an acrylic. When the light emitted from the light-emitting layer is extracted from the plastic film base material, it is preferred that the light permeability in the visible light range of the plastic film base material be 70% or more.

According to the detailed testing by the inventors, an amorphous tin-oxide type film has excellent gas-barrier characteristics. However, in order to realize the high-level gas-barrier characteristics, an amorphous structure is essential. When the structure is crystalline, crystal grain boundaries occur, and gas passes through those crystal grain boundaries, lowering the gas-barrier characteristics.

From the inventor's tests it was found that tin-oxide film containing no impurities satisfied the manufacturing conditions for the sputtering method, and particularly by optimizing the mixture amount of oxygen during sputtering, it is possible to obtain an amorphous film having excellent gas-barrier characteristics. Also, when manufacturing a film using the sputtering method, it is preferred that at least one added element selected from the group of silicon, germanium, titanium, aluminum, cerium and indium be added to the tin oxide at a ratio with respect to the total added element and tin of 0.2 to 45 atomic % because it becomes easier to form an amorphous structure under a wide range of film-formation conditions.

The amorphous tin-oxide type film described above also has good transparency in the visible light range.

In order to obtain an amorphous tin-oxide type film containing an added element that is added at the ratio described above, the oxide sintered body is made such that at least one added element selected from the group of silicon, germanium, titanium, aluminum, cerium and indium is included to the tin oxide at a ratio with respect to the total added element and tin of 0 to 45 atomic %, and more preferably 0.2 to 45 atomic %, the sputtering target is formed using this oxide sintered body, and then the film is formed using the sputtering method with this sputtering target.

In order to form a tin-oxide film, or in order to form a tin-oxide type film, it is particularly preferred that a sputtering method that uses the direct-current pulsing method be used. It is possible to use the RPG series by ENI, or the MDX-Sparc series or Pinnacle series by Advanced Energy, as the power supply for performing sputtering film formation using the direct-current pulsing method, however, the power supply is not limited to these. With the sputtering method using a direct-current pulsing method, it is possible to form an amorphous tin-oxide film or tin-oxide type film that has excellent surface smoothness and gas-barrier characteristics, and so it is possible to make a gas-barrier type transparent plastic substrate.

On the other hand, for a silicon oxynitride film that is formed using the sputtering method, unlike in the case of the tin-oxide film and tin-oxide type film, surface unevenness increases as the film thickness increases. Therefore, when using the sputtering method to form a silicon oxynitride film that is sufficiently thick (for example 200 nm) enough to have gas-barrier characteristics and that can be used for an organic EL display or the like, the surface unevenness becomes severe. Accordingly, by forming an amorphous tin-oxide type film on the bottom, it is possible to reduce the film thickness of the silicon oxynitride film that is formed on top of it, so it is possible to obtain a gas-barrier transparent plastic substrate having a smooth surface.

An amorphous tin-oxide type film has excellent acid-resistant properties, so a gas-barrier transparent plastic substrate formed by covering the surface of a plastic film base material with just a tin-oxide type film is not etched when etching the transparent electrode that is formed on that surface with acid, so it is possible to maintain the transmittance and gas-barrier characteristics of that transparent plastic substrate. The same is true for a gas-barrier transparent plastic substrate that is made by covering the surface of the amorphous tin-oxide type film of this invention with a silicon-oxynitride film or silicon-oxide film.

Moreover, in the case of the transparent oxide film of an amorphous tin-oxide type film, or a two-layer film that is formed by further forming a silicon-oxide film or silicon-oxynitride film on the top of that film as the aforementioned gas-barrier layer, it is preferred that the centerline average surface roughness Ra on the surface of the layer be 1.5 nm or less. When the centerline average surface roughness Ra on the surface is greater than 1.5 nm, minute protrusions exist on the surface when forming the transparent electrode film on the gas-barrier transparent plastic substrate having a gas-barrier layer, and electric current may become concentrated at the protrusions and leak, so it is not preferred. The centerline average surface roughness Ra on the film surface can be measured by an atomic force microscope (for example, a microscope by Digital Instruments), and it means, to be more precise, the centerline average surface roughness Ra of a 1 µm x 1 µm area on the film surface.

Furthermore, the gas-barrier transparent plastic film of this invention has a water-vapor transmission rate according to the Mocon method and measured according to method K7129-1992 of the JIS standards of 0.01 g/m²/day or less. When the water-vapor transmission rate is greater than 0.01 g/m²/day water-vapor penetrates into the organic EL display or high-definition color liquid-crystal display, and deterioration occurs at the boundary surface of the internal organic function layer causing pealing to occur, so use in a display is difficult.

In this invention, when a transparent electrode film is formed on the aforementioned gas-barrier transparent plastic substrate, it is preferred that the transparent electrode film have a surface resistance of 200 ohm/square, a smooth, and low-resistant amorphous structure. With regard to surface roughness, considering the use in organic EL or liquid-crystals, it is preferred that the centerline average surface roughness Ra on the surface of the transparent electrode film be 1.8 nm or less.

When indium oxide is used as the main component of the transparent electrode film with at least one element selected from the group of tin, tungsten, silicon or germanium added, it is possible that the transparent electrode film be formed using low-temperature sputtering and be a low-resistant (8 x 10⁻⁴ ohm cm) amorphous film. With an amorphous transparent electrode film, the smoothness of the electrode surface is good, so it is possible to use that transparent electrode film in the electrodes of a thin-film light-emitting cell such as in an organic EL display. Needless to say, the surface smoothness of the transparent electrode film is also affected by the surface unevenness of the transparent plastic substrate below it, so it is preferred that the transparent electrode film be formed on top of a smooth gas-barrier transparent plastic substrate having the structure of this invention.

Using the gas-barrier transparent plastic substrate of this invention, it is possible to form flexible organic EL display elements, which are one kind of flexible display element. An organic EL display elements comprises an anode, a cathode, and an organic layer that is located between both the anode and cathode, and this organic layer is constructed such that it contains an organic light-emitting layer that emits light by the reuniting of the electron holes that are supplied from the anode with the electrons that are supplied from the cathode. Organic EL display elements that are formed on top of the flexibly bendable plastic substrate are flexible organic EL display elements.

Below, an example of manufacturing an organic EL display elements will be explained. For example, a transparent electrode film used as an anode is formed on the gas-barrier transparent plastic substrate of this invention using the sputtering method. In this instance, it is preferred that the transparent electrode film have an amorphous structure with a smooth surface, and comprise indium oxide as the main component with at least one element selected from the group of tin, tungsten, silicon or germanium added. Next, using the vacuum evaporation method, α-naphthyl phenyl diamine (α-NPD) having a thickness of 50 nm is formed under the conditions described above as the electron-hole transport layer, after which, tris (8-quinolinol) aluminum (Alq) is deposited by vapor deposition under the same conditions to a thickness of 80 nm. The Alq also performs the function of an electron-hole transport layer. Then, a Magnesium-silver alloy is vapor deposited such that each element is deposited at the same time using separate boats, and where the speed of vapor deposition of magnesium and the speed of vapor deposition of silver is 1.0 nm/sec and 0.2 nm/sec, respectively; and by controlling the thickness with the aforementioned film-thickness-control apparatus, a film about 200 nm thick is formed. Using a metal mask during vapor deposition, a 2 mm wide band-shaped pattern is formed in a direction that orthogonally crosses the band-shaped pattern of the transparent electrode film and forms the cathode. Finally, by sputtering a silicon oxide to form a 200 nm thick protective film to cover the surface of the transparent electrode film, it is possible to obtain an organic EL display element. This kind of flexible organic EL display element uses the gas-barrier transparent plastic substrate of this invention that has excellent surface smoothness and gas-barrier characteristics, so it is possible to realize high moisture-proof characteristics and excellent light emittance. In the structure described above, the transparent electrode film is used as an electrode (anode) on the substrate side such that light is emitted from the substrate side.

Moreover, when the cathode (for example, magnesium-silver alloy or lithium fluoride) is formed in an ultrathin film (for example, 1 nm to 10 nm thick) with light transmittance, and then the transparent electrode film is formed on the cathode, light can be emitted from the opposite side of the substrate. In this case, it is preferred that the transparent electrode film have an amorphos structure with a smooth surface, and comprise indium oxide as the main component with at least one element selected from the group of tin, tungsten, silicon or germanium added.

Furthemore, reversing the order that the above thin films are formed on the gas-barrier transparent plastic substrate of this invention, an organic EL element which has a structure forming an cathode on the substrate side and an anode on the opposite side of the substrate can be made. In this case, when the transparent electrode film is used for an anode, light can be emitted from the opposite side of the substrate. Also, when a laminate film of the transparent electrode film and the ultrathin film (for example, 1 nm to 10 nm thick) of magnesium-silver alloy with light transmittance that is formed on the organic layer side, is used for a cathode, light can be emitted from the substrate side.

As flexible display elements used for electronic paper, there are liquid-crystal display elements, electrophoretic migration type display elements, toner display elements and the like, and each requires a gas-barrier transparent plastic substrate having a smooth surface and excellent gas-barrier characteristics, and the flexible display elements made using the gas-barrier transparent plastic substrate of this invention, make it possible to obtain display elements that are very durable and will have a long life.

### [Examples]

In making a gas-barrier transparent plastic substrate, a direct-current magnetron sputtering apparatus (Tokki Corporation, Model SPK503) having three 6-inch diameter cathodes as the non-magnetic target, was used.

A tin-oxide type sintered body sputtering target (manufactured by Sumitomo Metal Mining) for forming an amorphous transparent oxide film was attached to the first cathode, and a silicon-nitride target (manufactured by Sumitomo Metal Mining) for forming a silicon-oxynitride film or a silicon target (manufactured by Sumitomo Metal Mining) for forming a silicon oxide film, was attached to the second cathode. The plastic film base material on which the film is formed was capable of being moved and secured such that it faced each cathode, and the film was formed with it stationary and facing the cathodes.

### (Examples 1 to 9)

Formation of the amorphous oxide film was performed under the following conditions. A pure tin-oxide sintered body target, or an oxide sintered body target having tin-oxide as the main component and containing silicon (the ratio of the silicon contained being 0.2 to 45 atomic % of the total of silicon and tin) was attached to the first cathode, and the plastic film base material was placed directly on top of the first cathode. The distance between the target and plastic film base material was 60 mm.

A PES film (Sumitomo Bakelite Co., Ltd., FST-UCPES, 0.2 mm thickness) with an undercoat was used as the plastic film base material.

When the vacuum inside the chamber reached 1 x 10⁻⁴ Pa or less, 99.9999 mass % pure argon gas was put into the chamber at a gas pressure of 0.6 Pa, then in the argon gas containing 2% to 5% oxygen, an ENI manufactured RPG-50 was used as the direct-current power source to input 200 W direct-current power having 200 kHz direct-current pulsing between the target and plastic film, and plasma was generated by the direct-current pulsing; then a 100 nm to 200 nm thick pure tin-oxide film or tin-oxide film containing silicon was formed on the plastic film base material by sputtering. The film thickness was controlled by the film-formation time. In the case of tin-oxide film that contains silicon, the ratio of the silicon contained with respect to the total silicon and tin was changed in the range 0 to 45 atomic % by changing the amount of silicon contained in the tin-oxide target.

The crystallinity of the 100 nm to 200 nm thick pure tin-oxide film and tin-oxide film that contains silicon was measured by X-ray diffraction measurement, and the diffraction peak was looked for, however the diffraction peak could not be observed. Also, using an atomic force microscope (Digital Instruments; NS-III, D5000 System) the centerline average surface roughness Ra of a 1 µm x 1 µm area on the surface of the film was measured at 20 locations on the sample and the average value was found.

For the pure tin-oxide film, when the amount of oxygen during film formation by sputtering was 3% or less, the diffraction peak could not be observed, and the film was in a mixed state between a crystalline film and amorphous film; also, the Ra value was 5 nm or more, and the film had large surface unevenness. However, by controlling the amount of oxygen such that it was 4% or more, it was possible to obtain a film that was a complete amorphous film, and that had good surface smoothness with a Ra value of 0.8 nm to 1.5 nm. Moreover, tin-oxide film containing silicon at an amount less than 0.2 atomic % displayed the same properties as the pure tin-oxide film.

On the other hand, in the case of a tin-oxide film containing silicon at an amount of 0.2 atomic % or more, when the amount of oxygen during sputtering was 2% or more, the film was completely amorphous and had excellent surface smoothness (Ra value was 0.4 nm to 1.5 nm). A tin-oxide film that was formed by sputtering with an amount of oxygen of 1.5% or less was in a mixed state of a crystalline film and amorphous film, and the film had a high Ra value of 4.5 nm or greater and had large surface unevenness. From this it could be seen that by selecting the conditions for film formation it was possible to obtain a tin-oxide film that was amorphous and had good surface smoothness, and by including silicon at an amount of 0.2 atomic % or greater, it was possible to stably obtain an amorphous film having good surface smoothness over a wide range of film-formation conditions.

The water-vapor transmission rate of the PES film with under coat on which the 100 nm thick tin-oxide amorphous transparent oxide film and tin-oxide amorphous transparent oxide film containing silicon at 0.2 atomic % or greater was measured, and the result is shown in Table 1.

In Table 1, the film in Example 1 and Example 2 is completely amorphous tin-oxide film formed using a 4N purity tin-oxide target and with the amount of oxygen during sputtering being 5%. Also, the film in Examples 3 to 9 is tin-oxide film containing silicon and formed from a tin-oxide target containing silicon at respective amounts, and is amorphous film formed with the amount of oxygen during sputtering being 3 to 5%.

The water-vapor transmission rate was measured using the Mocon method, and measurement was performed using the MOCON PERMATRAN-W3/33 according to method K7129-1992 (temperature: 40 degrees C, humidity: 90% RH) of the JIS standards. It was found that the water-vapor transmission rate of the obtained film was less than the measurement limit (0.01 g/m²/day) of the Mocon method for each film, and each film functioned sufficiently as a moisture-proof film. Also, Table 1 shows the measurement results for the centerline average surface roughness Ra of a 1 µm x 1 µm area on the surface of the film that was measured using an atomic force microscope. The Ra values shown in Table 1 are the average values of measurements taken at 20 locations on the sample.

**[Table 1]**

| | Composition of Amorphous Tin-Oxide Film (Atomic Number Ratio of Si/(Si + Sn)) | Water-Vapor Transmittance by Mocon Method (g/m²/day) | Centerline Average Surface Roughness Ra(nm) |
|---|---|---|---|
| Example 1 | - | <0.01 | 1.5 |
| Example 2 | - | <0.01 | 1.3 |
| Example 3 | 0.002 | <0.01 | 0.8 |
| Example 4 | 0.050 | <0.01 | 0.8 |
| Example 5 | 0.15 | <0.01 | 1.0 |
| Example 6 | 0.20 | <0.01 | 0.7 |
| Example 7 | 0.35 | <0.01 | 0.9 |
| Example 8 | 0.41 | <0.01 | 1.0 |
| Example 9 | 0.45 | <0.01 | 0.9 |

As shown in Table 1, the film in each of Examples 1 to 9 had a water-vapor transmission rate of less than 0.01 g/m²/day, and had a water-vapor blockage less than the detection limit by the Mocon method. Also, the centerline average surface roughness Ra was found to be 1.5 nm or less, which is excellent surface smoothness.

The average visible light transmission rate of each of the gas-barrier transparent plastic substrates of Examples 1 to 9 at wavelengths of 400 nm to 800 nm was found to be 85% or greater, which is very good transparency.

The gas-barrier transparent plastic substrates of Examples 1 to 9 were submerged in an alkali solution (5% NaOH, 40 degrees C) for 5 minutes, however there was no change in the light transmission rate. Also, the gas-barrier transparent plastic substrates of Examples 1 to 9 were submerged in an acidic solution (15% HC1, 40 degrees C) for 5 minutes, however there was no change in the light transmission rate.

In this way, it was found that the gas-barrier transparent plastic substrates of Examples 1 to 9 had excellent alkali and acid resistance, and when wetting the transparent electrode film formed on top of the gas-barrier transparent plastic substrate and performing patterning, it was found that there was no change in the light transmission rate or gas-barrier characteristics even after being submerged in an acidic or alkali solution.

### (Example 10)

Using the same method as for Examples 3 to 9, a 100 nm thick amorphous tin-oxide film containing germanium was formed on the top of a PES film with an undercoat, and using the same methods, the water-vapor transmission rate and centerline average surface roughness Ra were measured.

The amorphous tin-oxide film containing germanium was formed from a tin-oxide sintered body target that contained germanium. The amount of the germanium contained in the amorphous tin-oxide film layer was changed by changing the amount of germanium in the target. By changing the amount of germanium contained in the target within the range 0.2 to 45 atomic % with respect to the total germanium and tin, a transparent oxide film was formed with the germanium content in the film at 0.2 to 45 atomic % with respect to the total germanium and tin.

The centerline average surface roughness Ra was measured for each of the formed 100 nm thick films under the same conditions as for Examples 1 to 9, and was found to be 0.6 nm to 1.3 nm, also the water-vapor transmission rate according to the Mocon method was less than 0.01 g/m²/day, so it was possible to form a high-quality gas-barrier transparent plastic substrate having good surface smoothness and high water-vapor barrier properties.

The tin-oxide film containing germanium described above was formed in an oxygen content of 3% to 5% during sputtering, and it was possible to stably obtain a smooth amorphous film under a wide range of film-formation conditions.

Also, the average transmission rate of visible light was measured using a spectrophotometer, and in each case the transmission rate was 85% or greater, which was very good. The gas-barrier transparent plastic substrate of Example 10 was submerged in an alkali solution (5% NaOH, 40 degrees C) for 5 minutes, however there was no change in light transmission rate. Also, the gas-barrier transparent plastic substrate of Example 10 was submerged in an acidic solution (15% HCl, 40 degrees C) for 5 minutes, however there was no change in light transmission rate.

In this way, it was found that the gas-barrier transparent plastic substrate of Example 10 had excellent alkali and acid resistance, and when wetting the transparent electrode film formed on top of the gas-barrier transparent plastic substrate and performing patterning, it was found that there was no change in the light transmission rate or gas-barrier characteristics even after being submerged in an acidic or alkali solution.

### (Example 11)

Using the same method as for Examples 3 to 9, a 100 nm thick amorphous tin-oxide film containing aluminum was formed on the top of a PES film with an undercoat, and using the same methods, the water-vapor transmission rate and centerline average surface roughness Ra were measured.

The amorphous tin-oxide film containing aluminum was formed from a tin-oxide sintered body target that contained aluminum. The amount of the aluminum contained in the amorphous tin-oxide film layer was changed by changing the amount of aluminum in the target. By changing the amount of aluminum contained in the target within the range 0.2 to 45 atomic % with respect to the total aluminum and tin, a transparent oxide film was formed with the aluminum content in the film at 0.2 to 45 atomic % with respect to the total aluminum and tin.

The centerline average surface roughness Ra was measured for the formed 100 nm thick film under the same conditions as for Examples 1 to 9, and was found to be 0.6 nm to 1.3 nm, also the water-vapor transmission rate according to the Mocon method was less than 0.01 g/m²/day, so it was possible to form a high-quality gas-barrier transparent plastic substrate having good surface smoothness and high water-vapor barrier properties.

The tin-oxide film containing aluminum described above was formed in an oxygen content of 3 to 5% during sputtering, and it was possible to stably obtain a smooth amorphous film under a wide range of film-formation conditions.

Also, the average transmission rate of visible light was measured using a spectrophotometer, and in each case the transmission rate was 85% or greater, which was very good. The gas-barrier transparent plastic substrate of Example 11 was submerged in an alkali solution (5% NaOH, 40 degrees C) for 5 minutes, however there was no change in light transmission rate. Also, the gas-barrier transparent plastic substrate of Example 11 was submerged in an acidic solution (15 % HCl, 40 degrees C) for 5 minutes, however there was no change in light transmission rate.

In this way, it was found that the gas-barrier transparent plastic substrate of Example 11 had excellent alkali and acid resistance, and when wetting the transparent electrode film formed on top of the gas-barrier transparent plastic substrate and performing patterning, it was found that there was no change in the light transmission rate or gas-barrier characteristics even after being submerged in an acidic or alkali solution.

### (Example 12)

Using the same method as for Examples 3 to 9, a 100 nm thick amorphous tin-oxide film containing cerium was formed on the top of a PES film with an undercoat, and using the same methods, the water-vapor transmission rate and centerline average surface roughness Ra were measured.

The amorphous tin-oxide film containing cerium was formed from a tin-oxide sintered body target that contained cerium. The amount of the cerium contained in the amorphous tin-oxide film layer was changed by changing the amount of cerium in the target. By changing the amount of cerium contained in the target within the range 0.2 to 45 atomic % with respect to the total cerium and tin, a transparent oxide film was formed with the cerium content in the film at 0.2 to 45 atomic % with respect to the total cerium and tin.

The centerline average surface roughness Ra was measured for the formed 100 nm thick film under the same conditions as for Examples 1 to 9, and was found to be 0.6 nm to 1.3 nm, also the water-vapor transmission rate according to the Mocon method was less than 0.01 g/m²/day, so it was possible to form a high-quality gas-barrier transparent plastic substrate having good surface smoothness and high water-vapor barrier properties.

The tin-oxide film containing cerium described above was formed in an oxygen content of 3% to 5% during sputtering, and it was possible to stably obtain a smooth amorphous film under a wide range of film-formation conditions.

Also, the average transmission rate of visible light was measured using a spectrophotometer, and in each case the transmission was 85% or greater, which was very good. The gas-barrier transparent plastic substrate of Example 12 was submerged in an alkali solution (5% NaOH, 40 degrees C) for 5 minutes, however there was no change in light transmission rate. Also, the gas-barrier transparent plastic substrate of Example 12 was submerged in an acidic solution (15% HCl, 40 degrees C) for 5 minutes, however there was no change in light transmission rate.

In this way, it was found that the gas-barrier transparent plastic substrate of Example 12 had excellent alkali and acid resistance, and when wetting the transparent electrode film formed on top of the gas-barrier transparent plastic substrate and performing patterning, it was found that there was no change in the light transmission rate or gas-barrier characteristics even after being submerged in an acidic or alkali solution.

### (Example 13)

Using the same method as for Examples 3 to 9, a 100 nm thick amorphous tin-oxide film containing indium was formed on the top of a PES film with an undercoat, and using the same methods, the water-vapor transmission rate and centerline average surface roughness Ra were measured.

The amorphous tin-oxide film containing indium was formed from a tin-oxide sintered body target that contained indium. The amount of the indium contained in the amorphous tin-oxide film layer was changed by changing the amount of indium in the target. By changing the amount of indium contained in the target within the range 0.2 to 45 atomic % with respect to the total indium and tin, a transparent oxide film was formed with the indium content in the film at 0.2 to 45 atomic % with respect to the total indium and tin.

The centerline average surface roughness Ra was measured for the formed 100 nm thick film under the same conditions as for Examples 1 to 9, and was found to be 0.6 to 1.3 nm, also the water-vapor transmission rate according to the Mocon method was less than 0.01 g/m²/day, so it was possible to form a high-quality gas-barrier transparent plastic substrate having good surface smoothness and high water-vapor barrier properties.

The tin-oxide film containing indium described above was formed in an oxygen content of 3 to 5% during sputtering, and it was possible to stably obtain a smooth amorphous film under a wide range of film-formation conditions.

Also, the average transmission rate of visible light was measured using a spectrophotometer, and in each case the transmission was 85% or greater, which was very good. The gas-barrier transparent plastic substrate of Example 13 was submerged in an alkali solution (5% NaOH, 40 degrees C) for 5 minutes, however there was no change in light transmission rate. Also, the gas-barrier transparent plastic substrate of Example 13 was submerged in an acidic solution (15% HC1, 40 degrees C) for 5 minutes, however there was no change in light transmission rate.

In this way, it was found that the gas-barrier transparent plastic substrate of Example 13 had excellent alkali and acid resistance, and when wetting the transparent electrode film formed on top of the gas-barrier transparent plastic substrate and performing patterning, it was found that there was no change in the light transmission rate or gas-barrier characteristics even after being submerged in an acidic or alkali solution.

### (Example 14)

A silicon-oxynitride film was formed on top of the amorphous transparent oxide film that was formed in Examples 1 to 13. In other words, a silicon-nitride target was placed on the second cathode, and the transparent plastic substrate that was obtained in Examples 1 to 13 was placed directly on top of the second cathode. The distance between the target and transparent plastic substrate was 60 mm.

At the instant when the vacuum inside the chamber reached 1 x 10⁻⁴ Pa, 99.9999 mass % pure argon gas was put inside the chamber, and with a gas pressure at 0.6 Pa and oxygen content of 1 % to 3% in the argon gas, 300W of high-frequency power was input between the target and transparent plastic substrate to generate high-frequency plasma, then a 100 nm thick silicon-oxynitride film was formed by sputtering on top of the amorphous transparent oxide film, to obtain the gas-barrier transparent plastic substrate of this example. The film thickness was controlled by the film-formation time. By changing the oxygen content in the sputtering gas, it was confirmed that silicon-oxynitride (SiON) film having a film composition ratio O/(O+N) of 0.3 to 0.95 was obtained. The film composition ratio was measured using EPMA.

The water-vapor transmission rate of the PES film with undercoat on which the formed gas-barrier transparent plastic substrate, or in other words, on which the amorphous transparent oxide film and silicon-oxynitride film were layered was evaluated. The water-vapor transmission rate was measured using the Mocon method and measurement was performed using a MOCON PERTMATRAN-W3/33 according to the K7129-1992 method of the JIS standards (temperature: 40 degrees C, humidity 90% RH). It was found that the obtained water-vapor transmission rate of the film in all cases was less than the measurement limit (0.01 g/m²/day) of the Mocon method, showing that the film functioned sufficiently as a moisture-proof film.

Also, the centerline average surface roughness Ra of a 1 µm x 1 µm area on the surface of the silicon-oxynitride film was measured using an atomic force microscope under the same conditions as in Examples 1 to 9, and was found to be 0.8 nm to 1.5 nm. Also, the average transmission rate of visible light that was measured using a spectrophotometer was 85% or greater, which was very good transparency.

The gas-barrier transparent plastic substrate of Example 14 was submerged in an alkali solution (5% NaOH, 40 degrees C) for 5 minutes, however there was no change in light transmission rate. Also, the gas-barrier transparent plastic substrate of Example 14 was submerged in an acidic solution (15% HC1, 40 degrees C) for 5 minutes, however there was no change in light transmission rate.

In this way, it was found that the gas-barrier transparent plastic substrate of Example 14 had excellent alkali and acid resistance, and when wetting the transparent electrode film formed on top of the gas-barrier transparent plastic substrate and performing patterning, it was found that there was no change in the light transmission rate or gas-barrier characteristics even after being submerged in an acidic or alkali solution.

### (Example 15)

A silicon-oxide film was formed on top of the amorphous transparent oxide film that was formed in Examples 1 to 13. In other words, a silicon target was placed on the second cathode, and the transparent plastic substrate that was obtained in Examples 1 to 13 was placed directly on top of the second cathode. The distance between the target and transparent plastic substrate was 60 mm.

At the instant when the vacuum inside the chamber reached 1 x 10⁻⁴ Pa, 99.9999 mass % pure argon gas was put inside the chamber, and with a gas pressure at 0.6 Pa and oxygen content of 10% in the argon gas, 300W of high-frequency power was input between the target and transparent plastic substrate to generate high-frequency plasma, then a 100 nm thick silicon-oxide film was formed by sputtering on top of the amorphous transparent oxide film, to obtain the gas-barrier transparent plastic substrate of this example. The film thickness was controlled by the film-formation time.

The water-vapor transmission rate of the PES film with undercoat on which the formed gas-barrier transparent plastic substrate, or in other words, on which the amorphous transparent oxide film and silicon-oxide film were layered was evaluated. The water-vapor transmission rate was measured using the Mocon method and measurement was performed using a MOCON PERTMATRAN-W3/33 according to the K7129-1992 method of the JIS standards (temperature: 40 degrees C, humidity 90% RH). It was found that the obtained water-vapor transmission rate of the film in all cases was less than the measurement limit (0.01 g/m²/day) of the Mocon method, showing that the film functioned sufficiently as a moisture-proof film.

Also, the centerline average surface roughness Ra of a 1 µm x 1 µm area on the surface of the silicon-oxide film was measured using an atomic force microscope, and was found to be 0.9 nm to 1.4 nm. Also, the average transmission rate of visible light that was measured using a spectrophotometer at a wavelength of 400 nm to 800 nm was 85% or greater, which was very good transparency.

The gas-barrier transparent plastic substrate of Example 15 was submerged in an alkali solution (5% NaOH, 40 degrees C) for. 5 minutes, however there was no change in light transmission rate. Also, the gas-barrier transparent plastic substrate of Example 15 was submerged in an acidic solution (15% HCl, 40 degrees C) for 5 minutes, however there was no change in light transmission rate.

In this way, it was found that the gas-barrier transparent plastic substrate of Example 15 had excellent alkali and acid resistance, and when wetting the transparent electrode film formed on top of the gas-barrier transparent plastic substrate and performing patterning, it was found that there was no change in the light transmission rate or gas-barrier characteristics even after being submerged in an acidic or alkali solution.

### (Comparative Examples 1 to 5)

A silicon-oxynitride film was formed directly on top of a plastic film base material. As in Example 14, PES film with an undercoat was used as the plastic film base material. Formation of the silicon-oxynitride film was performed under the conditions described in Example 14, and a 100 to 200 nm thick film was layered on the base material.

The water-vapor transmission rate of the PES film with undercoat on which the silicon-oxynitrde film was formed, in all cases was less than the measurement limit (0.01 g/m²/day) of the Mocon method, showing that the film functioned sufficiently as a moisture-proof film.

However, the centerline average surface roughness Ra of a 1 µm x 1 µm area on the surface of the silicon-oxynitride film was measured using an atomic force microscope under the same conditions as for Examples 1 to 9, and was found to be 2.5 nm to 3.6 nm, showing that the film had large surface unevenness when compared with the gas-barrier transparent plastic substrate formed in Examples 1 to 15 of the invention.

**[Table 2]**

| | Composition of Silicon-Oxide Film (Atomic number Ratio of O/(O + N)) | Water-vapor Transmittance by Mocon Method (g/m²/day) | Centerline Average Surface Roughness Ra(nm) |
|---|---|---|---|
| C-Example 1 | 0.42 | ≦ 0.01 | 3.5 |
| C-Example 2 | 0.53 | ≦ 0.01 | 2.8 |
| C-Example 3 | 0.65 | ≦ 0.01 | 2.5 |
| C-Example 4 | 0.72 | ≦0.01 | 3.2 |
| C-Example 5 | 0.80 | ≦ 0.01 | 3.0 |
| (C-Example = Comparative Example) | | | |

### (Comparative Example 6)

A silicon-oxide film was formed directly on top of a plastic film base material. As in Example 15, PES film with an undercoat was used as the plastic film base material. Formation of the silicon-oxide film was performed under the conditions described in Example 15, and a 100 nm to 200 nm thick film was layered on the base material.

The water-vapor transmission rate of the PES film with undercoat on which the silicon-oxide film was formed, in all cases was less than the measurement limit (0.01 g/m²/day) of the Mocon method, showing that the film functioned sufficiently as a moisture-proof film.

However, the centerline average surface roughness Ra of a 1 µm x 1 µm area on the surface of the silicon-oxide film was measured using an atomic force microscope under the same conditions as for Examples 1 to 9, and was found to be 2.8 to 4.3 nm, showing that the film had large surface unevenness when compared with the gas-barrier transparent plastic substrate formed in Examples 1 to 15 of the invention.

### (Example 16)

A transparent electrode film was formed on top of the gas-barrier transparent plastic substrate of Examples 1 to 15 using the procedure described below. That is, an oxide sintered body target containing indium oxide as the main component and also containing tungsten was attached to a third cathode, and the gas-barrier transparent plastic substrate of Examples 1 to 9 was placed directly on top of the third cathode. The distance between the target and the gas-barrier transparent plastic substrate was 60 mm.

At the instant when the vacuum inside the chamber reached 1 x 10⁻⁴ Pa or less, 99.9999 mass % pure argon gas was put inside the chamber, and with a gas pressure at 0.6 Pa and oxygen content of 1 to 3% in the argon gas, 200W of direct-current power was input between the target and substrate to generate direct-current plasma. By changing the amount of tungsten contained in the indium-oxide target of the third cathode, transparent electrode films were formed having various compositions with the amount of tungsten in the transparent electrode film with respect to the total indium and tungsten varying between 0.4 to 4.5 atomic %. In this way, a 120 nm to 200 nm thick indium-oxide film containing tungsten was formed on a transparent plastic substrate by sputtering, to obtain the transparent conductive substrate of this example.

The centerline average surface roughness Ra of the obtained transparent electrode film was found by performing measurements with an atomic force microscope at 20 locations in a 1 µm x 1 µm area of the sample, and was 0.6 to 1.8 nm, which showed good surface smoothness. The manufactured transparent electrode film was formed into a 2 mm wide band shape by etching. When doing this, the sheet resistance was 10 to 200 ohm/square.

### (Example 17)

A transparent electrode film was formed on top of the gas-barrier transparent plastic substrate of Examples 1 to 15 using the procedure described below. That is, an oxide sintered body target (ITO) containing indium oxide as the main component and also containing tin was attached to a third cathode, and the gas-barrier transparent plastic substrate of Examples 1 to 9 was placed directly on top of the third cathode. The distance between the target and the gas-barrier transparent plastic substrate was 60 mm.

At the instant when the vacuum inside the chamber reached 1 x 10⁻⁴ Pa or less, 99.9999 mass % pure argon gas was put inside the chamber, and with a gas pressure at 0.6 Pa and oxygen content of 1% to 3% in the argon gas, 200W of direct-current power was input between the target and substrate to generate direct-current plasma. By changing the amount of tin contained in the indium-oxide target of the third cathode, transparent electrode films were formed having various compositions with the amount of tin in the transparent electrode film with respect to the total indium and tin varying between 0.4 to 10.5 atomic %. In this way, a 50 nm to 200 nm thick indium-oxide film containing tin was formed on a transparent plastic substrate by sputtering, to obtain the transparent conductive substrate of this example.

The centerline average surface roughness Ra of the obtained transparent electrode film was found by performing measurements with an atomic force microscope under the same conditions as for Example 16 in a 1 µm x 1 µm area of the sample, and was 0.9 to 1.5 nm, which showed good surface smoothness. The manufactured transparent electrode film was formed into a 2 mm wide band shape by etching. When doing this, the sheet resistance was 18 to 180 ohm/square.

### (Example 18)

A transparent electrode film was formed on top of the gas-barrier transparent plastic substrate of Examples 1 to 15 using the procedure described below. That is, an oxide sintered body target containing indium oxide as the main component and also containing silicon was attached to a third cathode, and the gas-barrier transparent plastic substrate of Examples 1 to 9 was placed directly on top of the third cathode. The distance between the target and the gas-barrier transparent plastic substrate was 60 mm.

At the instant when the vacuum inside the chamber reached 1 x 10⁻⁴ Pa or less, 99.9999 mass % pure argon gas was put inside the chamber, and with a gas pressure at 0.6 Pa and oxygen content of 1 to 3% in the argon gas, 200W of direct-current power was input between the target and substrate to generate direct-current plasma. By changing the amount of silicon contained in the indium-oxide target of the third cathode, transparent electrode films were formed having various compositions with the amount of silicon in the transparent electrode film with respect to the total indium and silicon varying between 0.4 to 4.5 atomic %. In this way, a 50 nm to 200 nm thick indium-oxide film containing silicon was formed on a transparent plastic substrate by sputtering, to obtain the transparent conductive substrate of this example.

The centerline average surface roughness Ra of the obtained transparent electrode film was found by performing measurements with an atomic force microscope under the same conditions as for Example 16 in a 1 µm x 1 µm area of the sample, and was 0.4 nm to 1.2 nm, which showed good surface smoothness. The manufactured transparent electrode film was formed into a 2 mm wide band shape by etching. When doing this, the sheet resistance was 25 to 190 ohm/square.

### (Example 19)

A thin indium-oxide film containing zinc as an added material, or a thin indium-oxide film containing germanium as an added material, or a thin indium-oxide film containing tin and silicon as added materials, or a thin indium-oxide film containing tin and germanium as added materials, or a thin indium-oxide film containing tungusten and zinc as added materials, was formed using the same method and under the same conditions as in Examples 16 to 18, and the surface smoothness and sheet resistance were evaluated, and similarly, a low-resistant transparent conductive substrate having excellent surface smoothness was obtained.

### (Comparative Example 7)

Using the same method as in Example 16, a transparent electrode having similar composition was formed on the gas-barrier transparent plastic substrates of Comparative Examples 1 to 5. The obtained sheet resistance of the transparent electrode was the same as the value obtained in Example 16. However, using the same method and conditions as in Example 16, the centerline average surface roughness Ra of the transparent electrode film was measured using an atomic force microscope for a 1 µm x 1 µm area and found to be 4.4 nm to 6.5 nm, showing that the surface smoothness was poor. When flexible display elements such as organic EL display elements are formed on this kind of transparent electrode having severe unevenness, the light-emitting characteristics become poor and it is not possible to make elements having a long light-emitting life.

### [Industrial Applicability]

This invention makes it possible to provide a gas-barrier transparent plastic substrate that has excellent moisture-proof characteristics and surface smoothness; and the transparent conductive substrate that uses this gas-barrier transparent plastic substrate is extremely useful as material for electroluminescence (EL) display elements. Moreover, it is also useful as a substrate for a flexible organic EL display, which is gaining a lot of attention as a future display.

## Claims

1. A gas-barrier transparent plastic substrate comprising a plastic film base material and a gas-barrier layer formed on at least one surface of the plastic film base material, the gas-barrier layer having a tin-oxide type amorphous transparent oxide film.

2. A gas-barrier transparent plastic substrate comprising a plastic film base material and a gas-barrier layer formed on at least one surface of the plastic film base material, the gas-barrier layer having a tin-oxide type amorphous transparent oxide film, and a silicon-oxide film or silicon-oxynitride film.

3. The gas-barrier transparent plastic substrate described in Claim 1 or 2, wherein the tin-oxide type amorphous transparent oxide film comprises either of tin oxide, or tin oxide containing at least one added element that is selected from among the group of silicon, germanium, aluminum, cerium and indium.

4. The gas-barrier transparent plastic substrate described in Claim 3, wherein the added element is included at a ratio of 0.2 to 45 atomic % with respect to the total of added element and tin.

5. The gas-barrier transparent plastic substrate described in either of Claims 1 to 4, wherein a centerline average surface roughness Ra on a surface of the gas-barrier layer is 1.5 nm or less.

6. The gas-barrier transparent plastic substrate described in either of Claims 1 to 5, wherein a water-vapor transmission rate by the Mocon method and measured according to JIS standard method K7129-1992, is less than 0.01 g/m²/day.

7. A gas-barrier transparent conductive plastic substrate comprising the gas-barrier transparent plastic substrate described in either of Claims 1 to 6, and a transparent electrode film formed on the gas-barrier transparent plastic substrate, the transparent electrode film having a surface resistance of 200 ohm/square or less.

8. The gas-barrier transparent conductive plastice substrate described in Claim 7, wherein a centerline average surface roughness Ra on a surface of the transparent electrode film is 1.8 nm or less.

9. The gas-barrier transparent conductive plastic substrate described in Claim 7 or 8, wherein the transparent electrode film comprises indium oxide as the main component and at least one element selected from the group of tin, tungsten, silicon and germanium, and has an amorphous structure.

10. A flexible display element comprising the gas-barrier transparent plastic substrate described in either of Claims 1 to 6.

11. A flexible display element comprising the gas-barrier transparent plastic substrate described in either of Claims 1 to 6 and an organic electroluminescence display element formed on the gas-barrier transparent plastic substrate, the organic electroluminescence display element comprising an anode, a cathode, and an organic layer that is located between both the anode and cathode, and the organic layer containing an organic light-emitting layer that emits light by the reuniting of electron holes supplied from the anode with electrons supplied from the cathode.

12. A method of manufacturing the gas-barrier transparent plastic substrate described in either of Claims 1 to 9, a tin-oxide type sintered body being used as raw material and a sputtering method being used when manufacturing the tin-oxide type amorphous transparent oxide film.

13. The manufacturing method described in Claim 12, wherein a direct-current pulsing method is used as the sputtering method.

14. The manufacturing method described in Claim 12 or 13, wherein the tin-oxide type sintered body comprises either of tin oxide, or tin oxide containing at least one added element selected from among the group of silicon, germanium, aluminum, cerium, and indium.

15. The manufacturing method described in Claim 14, wherein the tin-oxide type sintered body contains the added element at a ratio of 0.2 to 45 atomic % with respect to the total amount of added element and tin.

16. A sputtering target comprising either of tin-oxide type sintered body that contains tin oxide, or tin-oxide type sintered body that contains tin oxide including at least one added element selected from the group of silicon, germanium, aluminum, cerium, and indium at a ratio of 0.3 to 45 atomic % with respect to the total amount of added element and tin.
